# EUROPEAN PATENT SPECIFICATION

(11) **EP 1 231 828 B1**
(45) Date of publication and mention of the grant of the patent: **12.04.2006**
(21) Application number: 00970114.5
(22) Date of filing: 27.10.2000
(51) Int. Cl.: H05K 13/00, H05K 13/04

(54) **DEVICE AND METHOD FOR MOUNTING PARTS**
BAUTEILBESTÜCKUNGSVORRICHTUNG UND VERFAHREN
DISPOSITIF ET PROCEDE POUR PARTIES D'ASSEMBLAGE

(30) Priority: 05.11.1999 JP 31515999
(43) Date of publication of application: 14.08.2002
(73) Proprietor: MATSUSHITA ELECTRIC INDUSTRIAL CO., LTD., Kadoma-shi, Osaka 571-8501 (JP)
(72) Inventor: UCHIYAMA, Hiroshi, Kofu-shi, Yamanashi 400-0056 (JP); OBARA, Hirofumi, Nakakoma-gun, Yamanashi 409-3851 (JP); MIMURA, Naoto, Higashiyatsushiro-gun, Yamanashi 406-004 (JP); OKUDA, Osamu, Nakakoma-gun, Yamanashi 409-3803 (JP); KABESHITA, Akira, Hirakata-shi, Osaka 573-0115 (JP)
(74) Representative: Eisenführ, Speiser & Partner
(86) International application number: PCT/JP2000/007522
(87) International publication number: WO 2001/035706

(56) References cited:
- JP-A- 3 289 197
- JP-A- 4 069 118
- JP-A- 2000 133 989
- US-A- 4 480 780

## Description

### Technical Field

The present invention relates to an apparatus and a method for mounting components whereby a plurality of components are placed to a mounting base object (a body to be mounted) such as a board or the like after the component supplied to a component supply position of a component supplying member for supplying the components one by one to the component supply position is held by a component holding member.

### Background Art

Component mounting apparatuses of various structures have been developed to respond to the need of high-speed mounting in recent years. For example, one of the apparatuses proposed has a plurality of component supply cassettes for storing a plurality of components in component supply tapes and supplying the respective components to the component supply positions, so that the components supplied to the component supply positions are sucked and held simultaneously by a plurality of suction nozzles and then placed to a board.

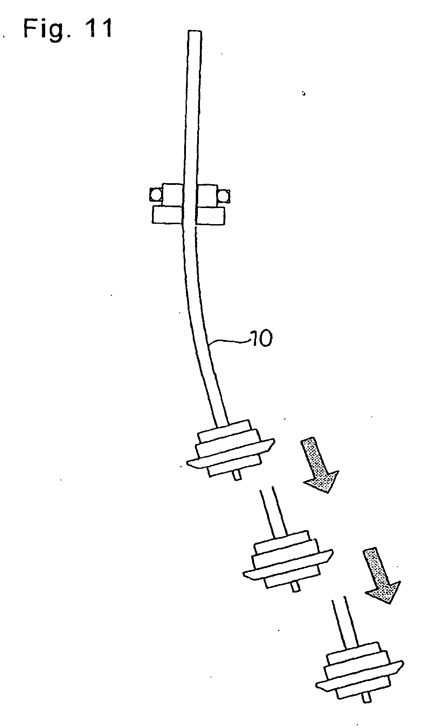

Meanwhile, a deflection resulting from a machining accuracy is inherent in a shaft of the nozzle as shown in Fig. 11. Even when each nozzle is positionally adjusted at an original position to a reference position along a reference center axis of the nozzle shaft (one-dotted chain line in the drawing), the nozzle has increased positional displacement at a nozzle leading end from the reference center axis of the shaft between the original position and a placing position lowered from the original position when the shaft is moved up and down by an actuator. In order for detecting such positional displacement thereby improving a component placing accuracy, the plurality of suction nozzles fitted to one head is recognized by a recognition camera in a state without sucking components and an amount of the positional displacement of each of the plurality of suction nozzles is detected between the original position and the placing position moved down from the original position. Each suction nozzle is rotated about its axis on the basis of the detected amount of the respective positional displacement to eliminate the positional displacement. The plurality of suction nozzles can accordingly simultaneously suck and hold the plurality of components supplied to the respective component supply positions by the plurality of component supply cassettes.

In the above structure, in the event that the detected positional displacement amount is too large to eliminate through the rotation of the suction nozzle about its axis, the suction nozzle with the large amount of the positional displacement has a large positional displacement amount from the component supply position of the component supply cassette and thus cannot suck and hold the component even when the plurality of components supplied from the plurality of component cassettes are to be sucked and held simultaneously by the plurality of component suction nozzles. Moreover, if the component cannot be correctly sent to the component supply position of the component supply cassette because of a positional displacement of the carrier tape holding the component which results from an attaching error of the carrier tape to the component supply cassette, the component cannot be sucked by the suction nozzle.

The present invention has for its object to provide an apparatus and a method for mounting components whereby components supplied from component supplying members can be simultaneously or continuously held by component holding members without being affected by a positional displacement of the component holding members to a head or a positional displacement of the component supplying members, etc., with an aim to solve the above-described issues.

### Disclosure Of Invention

In order to accomplish the above object, the present invention is constituted as described hereinbelow.

According to a first aspect of the present invention, there is provided a component mounting apparatus in which each of a plurality of components supplied to a component supply position of a component supplying member for supplying the components is held by a component holding member and then placed to a mounting base object,
the component holding member being set to a head which is movable in mutually orthogonal first direction and second direction, and
the component supplying member comprising a component supply driving device for moving the components one by one along the second direction to the component supply position, thereby moving the plurality of components one by one along the second direction to the component supply position by driving the component supply driving device,
said component mounting apparatus comprising a positional displacement detecting device for detecting a positional displacement along the second direction of the component holding member itself or of the component held by the component holding member to a reference position of the component holding member,
whereby a movement amount for moving the plurality of components one by one along the second direction to the component supply position is adjusted through driving control to the component supply driving device at the component supplying member where the component is to be held by the component holding member based on an amount of the positional displacement along the second direction of the component holding member itself or of the component held by the component holding member to the reference position of the component holding member which amount is operated on basis of detection result of the positional displacement detecting device, with the positional displacement amount being taken into account, so that the component supplied to the component supply position with the movement amount adjusted at the component supplying member is held by the component holding member including the positional displacement amount.

According to a second aspect of the present invention, there is provided a component mounting apparatus which a plurality of components supplied to corresponding respective component supply positions of a plurality of component supplying members for respectively supplying the components are respectively held by a plurality of component holding members and then placed to a mounting base object,
the plurality of component holding members being set to one head which is movable in mutually orthogonal first direction and second direction, and
each of the component supplying members comprising a component supply driving device for moving the plurality of components one by one along the second direction to the component supply position, thereby moving the plurality of components one by one along the second direction to the component supply position by driving the component supply driving device,
said component mounting apparatus being comprising a positional displacement detecting device for detecting a positional displacement along the second direction of each of the component holding members itself or of the component held by the component holding member to a reference position of each of the component holding members,
whereby a movement amount for moving the plurality of components one by one along the second direction to the component supply position is adjusted through driving control to each of the component supply driving devices at each of the component supplying members where the component is to be held by the component holding member based on an amount of the positional displacement along the second direction of each of the component holding members itself or of the component held by the component holding member to the reference position of each of the component holding members which amount is operated on basis of detection result of the positional displacement detecting device, with the positional displacement amount being taken into account, so that the respective components supplied to the respective component supply positions with the movement amounts adjusted at the respective component supplying members are held by the respective component holding members having the respective positional displacement amounts.

According to a third aspect of the present invention, there is provided a component mounting apparatus according to the second aspect, wherein the positional displacement detecting device can detect a positional displacement along the first direction of each of the plurality of component holding members itself or of the component held by the component holding member to the respective reference positions of the respective component holding members,
whereby an average value of the amounts of the positional displacement along the first direction of the component holding members themselves or of the components held by the component holding members to the respective reference positions of the respective component holding members which are operated on the basis of the detection result of the positional displacement detecting device is obtained, based on which a reference position of the head is adjusted before the components supplied to the component supply positions from the component supplying members are held by the plurality of component holding members.

According to a fourth aspect of the present invention, there is provided a component mounting apparatus according to the first aspect, in which, before holding components, whether or not the positional displacement amount is within a range correctable by driving control of the component supply driving device is judged, thereby adjusting the movement amount for moving the plurality of components one by one along the second direction to the component supply position through the driving control of the component supply driving device when the positional displacement amount is in the range, or moving the component holding member by the positional displacement amount along the second direction without executing the driving control of the component supply driving device when the positional displacement amount is outside the range.

According to a fifth aspect of the present invention, there is provided a component mounting apparatus according to either second or third aspect, in which whether or not each of the positional displacement amounts is in a range correctable by driving control of each of the component supply driving devices is judged, thereby adjusting the movement amount for moving the plurality of components one by one along the second direction to the component supply position through driving control of each of the component supply driving devices when all of the positional displacement amounts are within the range, or letting the other component holding members than the component holding member having the positional displacement amount outside the range hold the components when any of the plurality of positional displacement amounts is outside the range, moving the component holding members by an amount corresponding to the positional displacement amount outside the range along the second direction, and then, letting the component holding member having the positional displacement amount outside the range hold the component.

According to a sixth aspect of the present invention, there is provided a component mounting method for placing each of a plurality of components supplied to a component supply position of a component supplying member for supplying the components to a mounting base object after holding the component by a component holding member set to a head movable in mutually orthogonal first direction and second direction, the method comprising:
detecting a positional displacement along the second direction of the component holding member itself or of the component held by the component holding member to a reference position of the component holding member; and
whereby adjusting a movement amount for moving the plurality of components one by one along the second direction to the component supply position through driving control of a component supply driving device for moving the components one by one along the second direction to the component supply position at the component supplying member where the component is to be held by the component holding member based on an amount of the positional displacement along the second direction of the component holding member itself or of the component held by the component holding member to the reference position of the component holding member which amount is operated on basis of detection result at time of detecting the positional displacement, with the positional displacement amount being taken into account, and thus holding the component supplied to the component supply position with the adjusted movement amount at the component supplying member by the component holding member having the positional displacement amount.

According to a seventh aspect of the present invention, there is provided a component mounting method for respectively placing a plurality of components supplied to respective component supply positions from a plurality of component supplying members for respectively supplying the components to a mounting base object after respectively holding the components by a plurality of component holding members set to a head movable in mutually orthogonal first direction and second direction, the method comprising:
detecting a positional displacement along the second direction of each of the component holding members itself or of the component held by the component holding member to a reference position of each of the component holding members; and
whereby adjusting each movement amount for moving the plurality of components one by one along the second direction to the component supply position through driving control of a component supply driving device for moving the components one by one along the second direction to the component supply position at each component supplying member where the component is to be held by each of the component holding members based on an amount of each positional displacement along the second direction of the component holding member itself or of the component held by the component holding member to the reference position of each of the component holding members which amount is operated on basis of detection result at time of detecting the positional displacement, with each positional displacement amount being taken into account, and thus holding each component supplied to the component supply position with the adjusted movement amount at each component supplying member by each component holding member having the positional displacement amount.

According to an eighth aspect of the present invention, there is provided a component mounting method according to the seventh aspect, further comprising: detecting a positional displacement along the first direction of each of the component holding members itself or of the component held by the component holding member to the reference position of the component holding member at the detection time; and
obtaining an average value of the amounts of the positional displacement along the first direction of the component holding members themselves or of the components held by the component holding members to the reference positions of the component holding members which are operated on the basis of the detection result at the time of detecting the positional displacement; then, adjusting a reference position of the head based on the obtained average value; and thereafter holding the components supplied to the component supply positions from the component supplying members by the component holding members.

According to a ninth aspect of the present invention, there is provided a component mounting method according to the sixth aspect, further comprising judging whether or not the positional displacement amount is within a range correctable by driving control of the component supply driving device, thereby adjusting the movement amount for moving the plurality of components one by one along the second direction to the component supply position through the driving control of the component supply driving device when the positional displacement amount is in the range, or moving the component holding member by the positional displacement amount along the second direction without executing the driving control of the component supply driving device when the positional displacement amount is outside the range and thereafter holding the components.

According to a 10th aspect of the present invention, there is provided a component mounting method according to either seventh or eighth aspect, further comprising judging whether or not each of the positional displacement amounts is in a range correctable by driving control of each of component supply driving devices, thereby adjusting each movement amount for moving the plurality of components one by one along the second direction to the component supply position through the driving control of each of the component supply driving devices when all of the positional displacement amounts are within the range, or letting the other component holding members than the component holding member having the positional displacement amount outside the range hold components when any of the plurality of positional displacement amounts is outside the range; moving the head by an amount corresponding to the positional displacement amount outside the range along the second direction; and thereafter letting the component holding member having the positional displacement amount outside the range hold the component.

### Brief Description Of Drawings

These and other aspects and features of the present invention will become clear from the following description taken in conjunction with the preferred embodiments thereof with reference to the accompanying drawings, in which:
Fig. 1 is a perspective view of a component mounting apparatus according to one embodiment of the present invention;
Figs. 2A, 2B, 2C, and 2D are explanatory views of a state in which positional displacements of components at component supply positions of component supply cassettes in the component mounting apparatus are corrected, thereby enabling a plurality of nozzles to suck components at one time;
Figs. 3A, 3B, 3C, and 3D are explanatory views of a state in which a nozzle positional displacement amount in the component mounting apparatus is corrected, thereby enabling a plurality of nozzles to suck by two times;
Fig. 4 is a partial enlarged plan view explanatory of an adjustment state of a tape feed amount at the component supply cassettes of the component mounting apparatus;
Fig. 5 is a block diagram indicative of a relationship of a control part of the component mounting apparatus and the other devices or members;
Fig. 6 is a partial side view of the component supply cassette of the component mounting apparatus;
Fig. 7 is an explanatory view of a positional displacement in an X direction of a plurality of nozzles in the prior art;
Fig. 8 is an explanatory view for position adjustment to a positional displacement in a Y direction at the component supply cassette in the prior art;
Fig. 9 is an explanatory view of the positional displacement in the X direction of a plurality of nozzles in the embodiment;
Fig. 10 is an explanatory view for adjustment to the positional displacement in the Y direction at the component supply cassette; and
Fig. 11 is an explanatory view of the positional displacement caused by a shaft deflection.

### Best Mode for Carrying Out the Invention

Before the description of the present invention proceeds, it is to be noted that like parts are designated by like reference numerals throughout the accompanying drawings.

Embodiments of the present invention will be described below in detail on the basis of drawings.

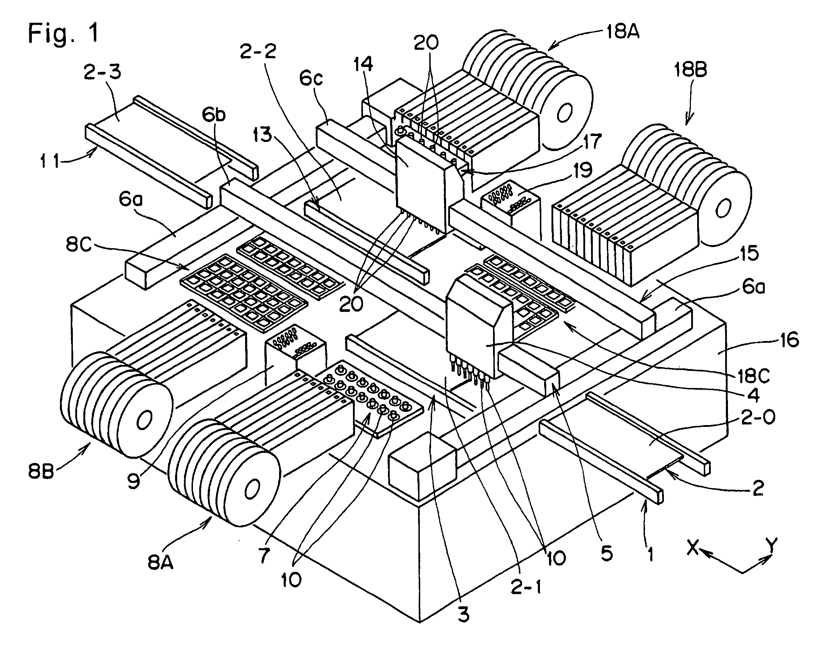

A schematically perspective view of the whole of a component mounting apparatus according to one embodiment of the present invention is shown in Fig. 1.

In Fig. 1, reference numeral 1 is a loader for carrying in a circuit board 2-0 (designated by a reference numeral 2 to show the board irrespective of a position, and designated by reference numerals 2-0, 2-1, 2-2, 2-3 and the like to show boards of specific positions), and reference numeral 11 is an unloader for carrying out the circuit board 2-3. Reference numeral 3 is a first board transferring holding device with a pair of support rail parts for transferring and holding the circuit board 2 carried in from the loader 1. Reference numeral 4 is a working head having a plurality of, e.g., 10 component suction nozzles 10 fitted replaceably for sucking and holding components. The component suction nozzle is an example of the component holding member. Reference numeral 5 is an XY robot for positioning the working head 4 to a predetermined position in two XY directions orthogonal to each other within a component mounting working area. Reference numeral 7 is a nozzle station arranged in the vicinity of a component supply part 8A of the component mounting working area, where nozzles 10 of a plurality of kinds stored conforming to components of a plurality of kinds are replaced with nozzles 10 fitted to the working head 4 upon necessities. Reference numerals 8A, 8B are component supply parts arranged in front of the component mounting working area to workers, that is, a forward end part, with having a plurality of component supply cassettes 80 for storing components 103 to be mounted to the board 2 in component storage recesses 102 of a carrier tape 101 one by one and supplying the components 103 to component supply positions 89 one by one. Reference numeral 8C is a component supply part disposed in the vicinity of the component supply part 8B for storing and holding tray components to be mounted to the board 2 in a tray. Reference numeral 9 is a recognition camera set to the side closer to the center of the component mounting working area near the component supply part 8A for picking up images of suction postures of components sucked by the nozzles 10 of the working head 4.

On the other hand, reference numeral 13 is a second board transferring holding device with a pair of support rail parts for transferring and holding the circuit board 2-1 sent from the first board transferring holding device 3. Reference numeral 14 is a working head having a plurality of, for instance, 10 component suction nozzles 10 as an example of the component holding member replaceably set for sucking and holding components. Reference numeral 15 is an XY robot for positioning the working head 14 to a predetermined position in two orthogonal XY directions in the component mounting working area. Reference numeral 17 is a nozzle station disposed in the vicinity of the component supply part 18A where nozzles 10 of a plurality of kinds fit to components of a plurality of kinds are stored and replaced with nozzles 10 set to the working head 14 if necessary. Reference numerals 18A, 18B are component supply parts set in back of the component mounting working area to the workers, i.e., a rear end part of the apparatus, having a plurality of component supply cassettes 80 in which components 103 to be mounted to the board 2-1 are stored one by one in component storage recesses 102 of the carrier tape 101 for supplying the components 103 one by one to the component supply positions 89. Reference numeral 18C is a component supply part disposed in the vicinity of the component supply part 18B for storing and holding tray components to be mounted to the board 2 in a tray. Reference numeral 19 is a recognition camera arranged to the side closer to the center of the component mounting working area in the vicinity of the component supply part 18A for picking up images of suction postures of the components sucked by the nozzles of the working head 14.

The above XY robots 5, 15 are constructed as described below. Two Y-axis driving parts 6a, 6a of an XY robot device 6 are fixedly arranged to a front and a rear edges of a component mounting working area 200 on a mounting apparatus base 16. Two X-axis driving parts 6b, 6c intersecting the two Y-axis driving parts 6a, 6a are arranged independently movably in an Y-axis direction to be able to avoid collision. Moreover, the working head 4 which can move within a mounting area of the front half of the component mounting working area is set to the X-axis driving part 6b to be movable in an X-axis direction, and the working head 14 which can move in a working area of the rear half of the component mounting working area is set to the X-axis driving part 6c to be movable in the X-axis direction. The XY robot 5 is thus constituted of the two Y-axis driving parts 6a, 6a fixed to the mounting apparatus base 16, the X-axis driving part 6b movably in the Y-axis direction on the Y-axis driving parts 6a, 6a, and the working head 4 movably in the X-axis direction at the X-axis driving part 6b. The XY robot 15 is constituted of the two Y-axis driving parts 6a, 6a fixed to the mounting apparatus base 16, the X-axis driving part 6c movably in the Y-axis direction on the Y-axis driving parts 6a, 6a, and the working head 14 movably in the X-axis direction at the X-axis driving part 6c. The working heads 4, 14 can accordingly move in the XY directions independently of each other.

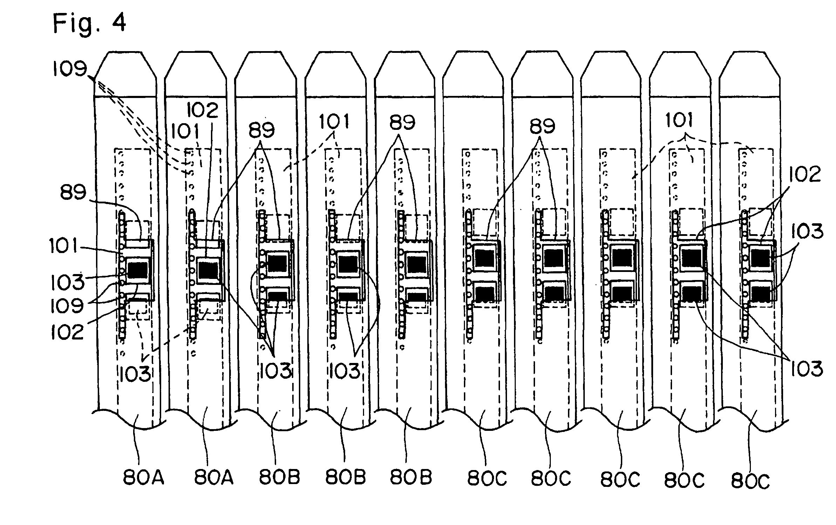

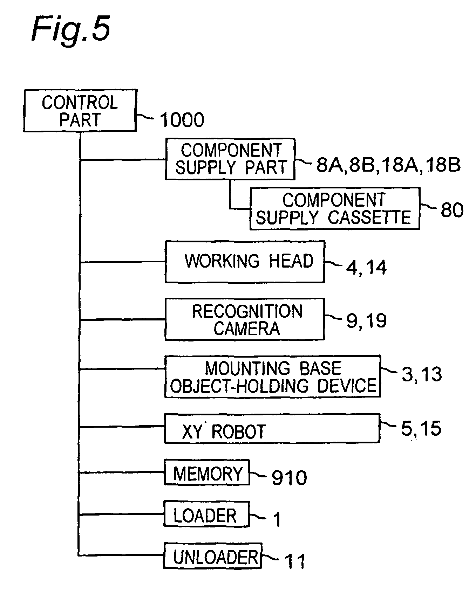

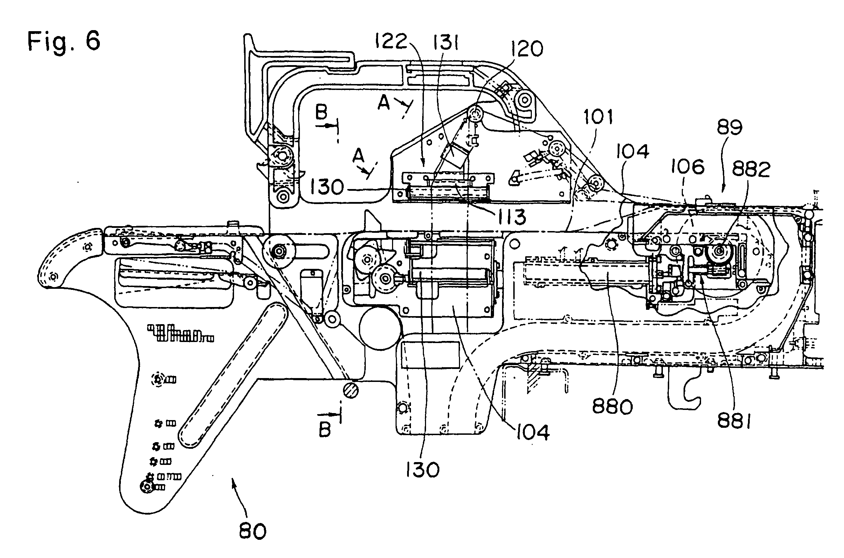

As shown in Figs. 4 and 6, a sprocket 106 set to a leading end of each component supply cassette 80 of the component supply parts 8A, 8B, 18A, 18B is engaged with feed holes 109 formed continuously via an equal distance to a side end part of the carrier tape 101. The sprocket 106 has a driving gear 882 fixed thereto. The driving gear 882 is coupled via a gear transmission mechanism 881 to a component supply driving device, for example, a pulse motor 880. When the sprocket 106 is rotated by a predetermined amount by the pulse motor 880 via the gear transmission mechanism 881 and the driving gear 882, the carrier tape 101 is sent by a predetermined pitch, whereby the components 103 stored and held one by one in the component storage recesses 102 of the carrier tape 101 are positioned one by one to the component supply position 89 formed as a component supply opening of the cassette 80 and, supplied for holding. A send amount of the carrier tape 101 can be changed by adjustment of a rotation amount of the pulse motor 880 through driving control of the pulse motor 880 by a control part 1000 (referring to Fig. 5). The component storage recess 102, namely, component 103 can be changed in position at the component supply position 89 in the Y direction in this manner.

The control part 1000 is provided for controlling the above operations of carrying in and carrying out boards, holding components, recognizing components, placing components, and the like, and is connected to the component supply parts 8A, 8B, 18A, 18B, the component supply cassettes 80, the working heads 4, 14, recognition cameras 9, 19, devices 3, 13 for holding mounting base objects (bodies to be mounted), XY robots 5, 15, a memory 910, the loader 1, the unloader 11, etc. The memory 910 stores NC data indicating a mounting program that which component is to be placed to which position in which order or the like, an arrangement program that which component is to be arranged to which component supplying member or arrangement information that the components have been arranged, a component library of component information related to a shape, a height, and the like of each component, board information related to a shape of each board, the other information such as information on a shape of the component suction nozzles, a board transfer position of each support rail part, and the like.

The above recognition camera 9, 19 not only picks up images of the suction postures of components sucked by the nozzles 10 as described above, but also functions as a positional displacement detecting device for detecting a positional displacement of each suction nozzle 10 itself to a reference position thereof. More specifically, a nozzle shaft generates an initial positional displacement between an original position of the nozzle and a placing position lowered from the original position because of a machining accuracy or the like reason when each nozzle 10 moves up and down. In order to correct (calibrate) the initial positional displacement of each suction nozzle 10 which is generated at the nozzle shaft in this manner, each suction nozzle 10 moved down to a position corresponding to the placing position in a state with sucking and holding a calibration jig similar to the component to be sucked or in a state without sucking and holding anything is rotated by θ about its axis, and the initial positional displacements in each of the X and Y directions to the reference position, i.e., a reference center axis of the shaft (one-dotted chain line in the drawing) are detected.

The detection result recognized, that is, detected by the recognition cameras 9, 19 in this manner is input to the control part 1000. The control part 1000 operates an initial positional displacement amount Δx in the X direction and an initial positional displacement amount Δy in the Y direction at the time when the nozzle 10 is rotated by θ with respect to the reference position on the basis of information of the detection result with using a position where the nozzle 10 is to be normally positioned, i.e., the reference center axis of the nozzle shaft as the reference position, and thus obtains the initial positional displacement amount Δx in the X direction and the initial positional displacement amount Δy in the Y direction. The obtained initial positional displacement amount Δx in the X direction and the initial positional displacement amount Δy in the Y direction are stored in the memory 910. The control part 1000 specifies, with reference to the mounting program stored in the memory 910, each component supply cassette 80 to which each suction nozzle 10 executes a component suction operation next. The control part 1000 sends the operated initial positional displacement amount Δy in the Y direction with respect to the reference position of the suction nozzle 10 as initial correction information (correction information for the nozzle) to a pulse motor driving control part (not shown) for adjusting the rotation amount of the pulse motor 880 of the specified component supply cassette 80. Based on the initial correction information, the rotation amount of each pulse motor 880 is adjusted at the pulse motor. By the arrangement whereby the rotation amount of each pulse motor 880 is adjusted on the basis of the respective initial correction information with the initial positional displacement amount of each suction nozzle 10 being taken into account at each component supply cassette 80 from which the next component is to be sucked by the suction nozzle 10, a movement amount for moving each component 103 to the component supply position 89 along the Y direction is adjusted and the position of the component at the component supply position 89 is adjusted. Accordingly, each component 103 is positioned to a position to respond to the initial positional displacement of the nozzle 10 which next sucks the component, thereby absorbing the initial positional displacement amount of the nozzle 10. The component 103 at the component supply position 89 can hence be surely sucked and held by the nozzle 10. Since the above initial correction information is specific information for each nozzle 10, the information is sent to the component supply cassette 80 corresponding to the nozzle 10 before the nozzle 10 performs the next component suction operation, with which the rotation amount of the corresponding pulse motor 880 is adjusted. This operation of detecting the initial positional displacement and operating the initial correction information can be executed, for instance, for each nozzle 10 at the start of production, for each nozzle 10 every time a predetermined amount of bodies to be mounted such as boards or the like are produced, or every time a production type of the bodies to be mounted is changed.

An operation of mounting can be carried out in a manner to be described below in a state where the initial positional displacement is corrected as above.

Suction nozzles 10, ..., 10 fitted to each of the working heads 4, 14 of the XY robots 5, 15 movable in the XY directions of the component mounting apparatus operate as follows. Here, the nozzles 10, ..., 10 of the two working heads 4, 14 operate in an equal fashion in an equal structure and therefore, the description is directed to the suction nozzles 10, ..., 10 of the working head 4 of the XY robot 5 as a representative example.

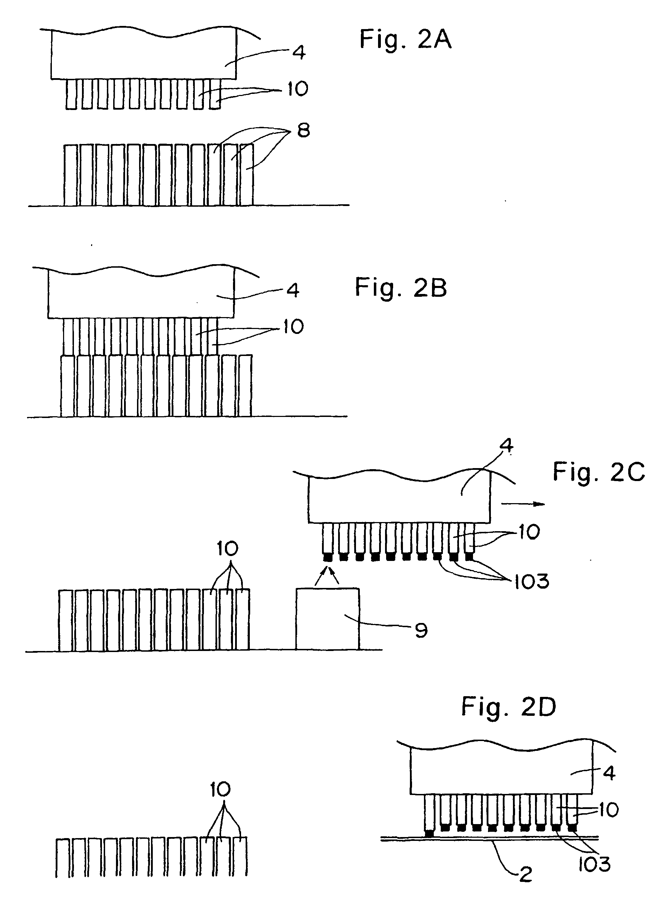

In Fig. 2A, each of the ten suction nozzles 10, ..., 10 is moved by the working head 4 based on driving of the XY robot 5 under control of the control part 1000 to a suction preparation position above the component supply position 89 of each of the ten component supply cassettes 80.

Next, as shown in Fig. 2B, the ten suction nozzles 10 move down towards the corresponding component supply positions 89 from the suction preparation positions concurrently. After simultaneously sucking and holding ten components 103, ..., 103 arranged to the ten component supply positions 89 at one time, the suction nozzles move up to the suction preparation positions again.

Then, as shown in Fig. 2C, the suction nozzles move towards the recognition camera 9 from the suction preparation positions in consequence of the driving of the XY robots. While the ten suction nozzles are moving over the recognition camera 9, the recognition camera 9 recognizes positions, postures, shapes, or the like of the ten components 103, ..., 103.

Next, as shown in Fig. 2D, upon completion of the recognition, the head 4 is controlled to drive in the XY directions or each nozzle 10 is controlled to rotate by θ upon necessities to correct the posture or position of each of the 10 components 103, ..., 103 under control of the control part 1000 based on the recognition result. The components are then placed respectively to predetermined placing positions of the board 2.

Since the rotation amount of each pulse motor 880 of the component supply cassette 80 is adjusted to correct the initial positional displacement on the basis of the initial correction information in this manner, the positional displacement in the Y direction of each nozzle 10 is absorbed, enabling the components to be more surely sucked and held.

However, in the case of placing minute components such as minute IC chips or the like to the body to be mounted such as the board or the like, a positional displacement or an error in feed amount as a result of a mounting error of the carrier tape 101 accommodating the components 103 to the component supply cassette 80, a biased position of each component 103 in the component storage recess 102, or the like sometimes becomes an impediment to correct transfer for the component 103 to the component supply position 89 of the component supply cassette 80. The nozzle 10 cannot suck and hold the component in such a case. For solving this, correction information for the side of the component supply cassette is obtained as will be discussed below, and on the basis of this component supply cassette-side correction information in addition to the earlier-described initial correction information, the component 103 at the component supply position 89 of the component supply cassette 80 is positionally adjusted, whereby each nozzle 10 can stably and properly suck and hold the component, with a suction rate at each nozzle 10 being improved.

Specifically, when each component 103 is sucked and held by each nozzle 10 as shown in Figs. 2A and 2B and then recognized as to the posture and the like by the recognition camera 9 as in Fig. 2C, a positional displacement amount in the Y direction of each component 103 obtained by the control part 1000 from the recognition result is compared with the initial positional displacement amount of each nozzle, thereby obtaining the positional displacement amount Δy in the Y direction generated when the component is sucked in this time. The obtained positional displacement amount Δy in the Y direction is stored as the correction information for the component supply cassette into the memory 910. The correction information for the component supply cassette is sent to the corresponding component supply cassette 80, where the rotation amount of the pulse motor 880 is adjusted on the basis of both the sent correction information for the component supply cassette and the initial correction information based on the initial positional displacement of the nozzle 10 next to suck the component. In consequence, the movement amount for moving each component 103 to the component supply position 89 along the Y direction is adjusted, and the position of the component 10 at the component supply position 89 is adjusted. According to the arrangement, each component 103 is positioned to a position conforming to the initial positional displacement of each nozzle 10 which is to suck the component next and to the positional displacement of the component supply cassette, so that the initial positional displacement amount of the nozzle 10 and the positional displacement amount of the component supply cassette are absorbed. Each of the nozzles 10 is enabled to more surely suck and hold the component 103 at the component supply position 89 as shown in Figs. 2A and 2B.

By way of example, when a first nozzle 10 at an end part of the ten nozzles 10 includes the initial positional displacement amount Δy in the Y direction of 0.5mm, the rotation amount of the pulse motor 880 at an 11th component supply cassette 80 estimated to be sucked by the first nozzle 10 is adjusted, thereby shifting the component 103 by 0.5mm from a predetermined reference position at the component supply position 89. Consequently the first nozzle 10 including the initial positional displacement amount Δy of 0.5mm in the Y direction can surely suck and hold the component 103 shifted by 0.5mm at the component supply position 89. Moreover, if the component 103 after sucked is recognized to include a positional displacement amount of 1.2mm, 0.7mm as a difference therebetween is judged to be the positional displacement amount at the side of the 11th component supply cassette generated when the component is sucked, and the rotation amount of the pulse motor 880 for the 11th component supply cassette 80 is adjusted to further shift the component 103 at the component supply position 89 by 0.7mm. Sucking and holding minuter components is effectuated in this manner. In the case where the nozzle 10 which is to next suck and hold to the 11th component supply cassette 80 is a fifth nozzle 10 and the fifth nozzle 10 includes the initial positional displacement amount of 0.3mm in the Y direction, the 11th component supply cassette 80 is adjusted to shift the component 103 at the component supply position 89 by a sum, i.e., 1.0mm of the positional displacement amount 0.7mm specific to the 11th component supply cassette 80 and the positional displacement amount 0.3mm specific to the fifth nozzle 10.

In the above-described embodiment, the control part 1000 judges whether or not the positional displacement amount at the side of the component supply cassette is in a range correctable by adjustment to the pulse motor 880. If the positional displacement amount is in the range correctable by the adjustment, the drive of the pulse motor 880 is controlled thereby adjusting the position of the component 103 at the component supply position 89 and absorbing the positional displacement of the component supply cassette. On the other hand, if the positional displacement amount is out of the correctable range, the drive of the pulse motor 880 is not controlled and the simultaneous suction at one time can be switched to a suction operation by a plurality of number of times without performing the simultaneous suction.

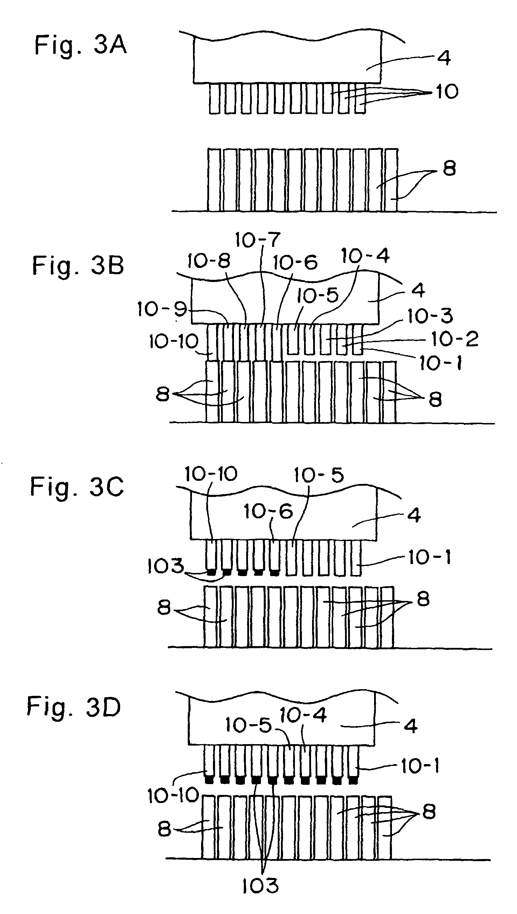

More specifically, as shown in Figs. 3 and 4, only the components in a simultaneous suctionable range where the components can be sucked simultaneously at one time are set as one group and, sucked and held simultaneously at one time by the nozzles 10 in the group among, e.g., ten nozzles 10, ..., 10. Thereafter, the head 4 can be moved in the Y direction to suck component(s) by nozzle(s) 10 that could not suck the component(s) before the pervious suction.

Fig. 3 is a diagram of a case in which a first and a second two component supply cassettes 80A, 80A from the left end among the component supply cassettes 80 set in the simultaneous suctionable range can position respective components 103, 103 to proper supply positions, a third through a fifth three component supply cassettes 80B, ..., 80B can position components 103 to supply position allowable limits and, the remaining five, namely, a sixth through a 10th component supply cassettes 80C, ..., 80C can position components 103, ..., 103 to suction impossible positions. The suction operation to be described below is carried out to these first-10th component supply cassettes.

As indicated in Fig. 3A, under control of the control part 1000, the ten suction nozzles 10, ..., 10 are moved by the working head 4 based on the driving of the XY robot 5 to suction preparation positions above respective component supply positions 89 of the first-10th component supply cassettes 80A, ... 80C.

Next, as shown in Fig. 3B, the first and second component supply cassettes 80A, 80A and the third-fifth component supply cassettes 80B, ..., 80B in the simultaneous suctionable range are set in one group. A first-a fifth nozzles 10, ..., 10 executes simultaneous suction to the five component supply cassettes at one time. That is, the first-fifth nozzles 10, ..., 10 simultaneously move down to the corresponding component supply positions 89 from the suction preparation positions, simultaneously suck and hold a batch of five components 103, ..., 103 present at the five component supply positions 89, ..., 89, and thereafter move up to the suction preparation positions.

Then, as shown in Fig. 3C, the head 4 moves along the Y direction to move the nozzles 10, ..., 10 to a position where the nozzles can simultaneously suck to a group of the remaining sixth-10th component supply cassettes 80C, ..., 80C at one time. At this time, the first-fifth nozzles 10, ..., 10 still suck and hold the components 103, ..., 103.

Next, as shown in Fig. 3D, a sixth-a 10th nozzles 10, ..., 10 simultaneously suck to a group of the sixth-10th component supply cassettes 80C, ..., 80C at one time. That is, the sixth-10th nozzles 10 simultaneously move down to the corresponding component supply positions 89 from the suction preparation positions, simultaneously suck and hold five components 103, ..., 103 placed at the five component supply positions 89, ..., 89 at one time, and then move up back to the suction preparation positions.

Recognition and placing are executed afterwards as shown in Figs. 2C and 2D.

The positional displacement in the X direction is also corrected as will be described below according to the embodiment.

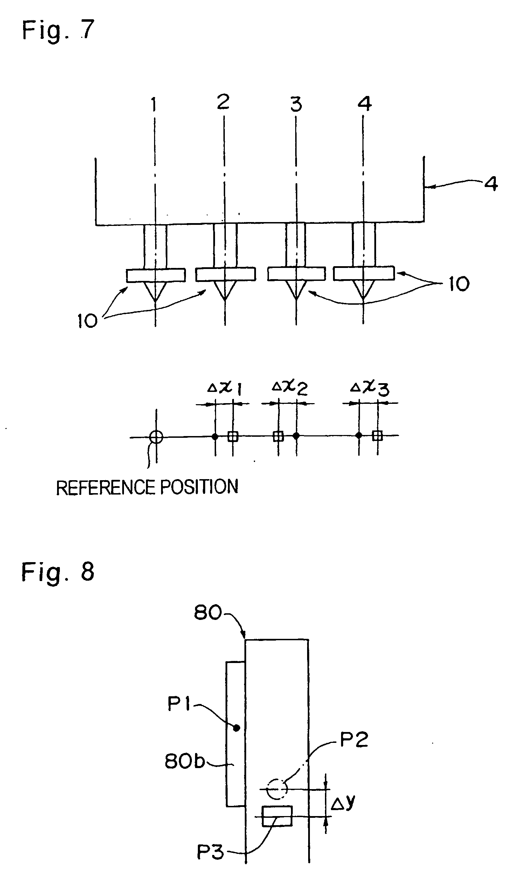

Referring to Fig. 7, the positional displacement is generally generated in the X direction of the nozzle 10 between the normal reference position and an actual position because of the machining accuracy. Conventionally, the positional displacement has been corrected by registering the first nozzle 10 (nozzle designated by a number 1 in Fig. 7) to the reference position, thereafter mechanically adjusting positional displacement amounts Δx₁-Δx₃ between the normal reference position (indicated by black circles in Fig. 7) and the actual position (indicated by square marks in Fig. 7) of the other nozzles (for example, second to fourth nozzles 10 designated by numbers 2, 3, 4 in Fig. 7), thereby registering the other nozzles to the normal reference positions to enable simultaneous suction at one time. However, it was difficult to mechanically adjust the ten nozzles 10, ..., 10.

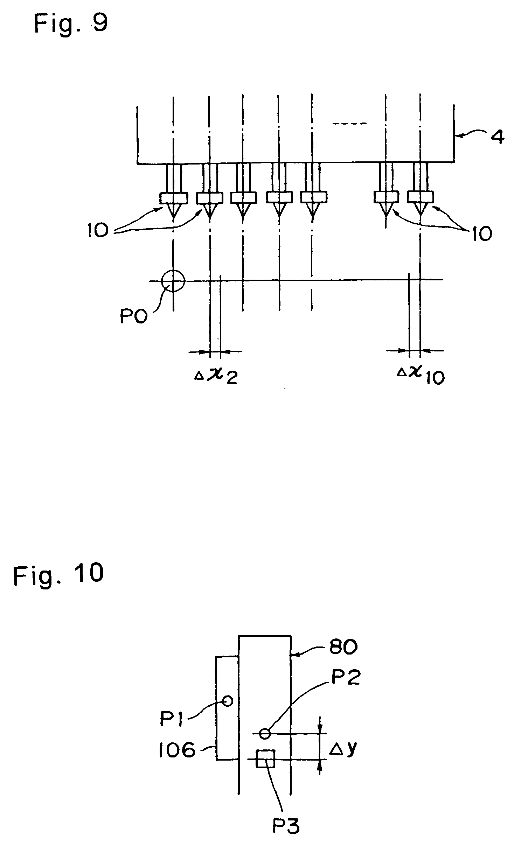

In contrast, according to the embodiment as shown in Fig. 9, the first nozzle 10 (left end nozzle in Fig. 9) is registered to the reference position at the calibration time described earlier, then the positional displacement amounts Δx, specifically, ΔX₂-ΔX₁₀ in the X direction between the normal reference positions (indicated by black circles in Fig. 9) and the actual positions of the other second-fourth nozzles 10, ..., 10 are obtained by the control part 1000. The control part 1000 obtains an average value of the positional displacement amounts Δx₂-Δx₁₀, adjusts the driving control of the working head 4 to shift a reference position of the working head 4, i.e., the reference positions of the first-10th nozzles 10, ..., 10 by the average value. Since the positional displacement amounts in the X direction are averaged, a degree of effects of the positional displacements is decreased and the labor for mechanical adjustment is saved. The nozzles can more surely and more stably suck components with an individual nozzle suction rate improved.

In the embodiment, the positional displacement of the nozzle 10 along the Y direction to the reference position is detected and, the control part 1000 controls the driving of the pulse motor 880 for moving the components one by one along the Y direction to the component supply position 89 at the component supply cassette 80 where the component is to be held by the nozzle 10 based on the amount of the positional displacement of the nozzle 10 along the Y direction to the reference position which amount is operated on the basis of the detection result when the positional displacement is detected, with the amount of the positional displacement being taken into account, whereby the movement amount for moving the plurality of components 103 one by one along the Y direction to the component supply position 89 is adjusted and the component 103 at the component supply position 89 can be adjusted positionally. Therefore, the nozzle 10 including the positional displacement amount can hold the component 103 supplied to the component supply position 89 with the movement amount adjusted at the component supply cassette 80. The components can be stably and properly sucked and held by the component supply cassettes 80. A suction rate at the component supply cassettes 80 can be improved.

According to the second and seventh aspects of the present invention, the positional displacement along the Y direction of each of a plurality of nozzles 10, ..., 10 to the reference position is detected. Each component supply cassette 80 where the component is to be held by each nozzle 10 is controlled based on the amount of the positional displacement of the nozzle 10 along the Y direction to the reference position which amount is operated on the basis of the detection result when the above positional displacement is detected, through the driving control of the pulse motor 880 which moves the plurality of components 103 one by one along the Y direction to the component supply position 89 with the positional displacement amount being taken into account, whereby the movement amount for moving the plurality of components 103 one by one along the Y direction to the component supply position 89 is adjusted and therefore the position of each component 103 at the component supply position 89 is adjusted. Even when the plurality of nozzles 10, ..., 10 are to suck the plurality of components 103, ..., 103 simultaneously at one time, each of the nozzles 10 including the positional displacement amount can hold the component 103 supplied to the component supply position 89 with the movement amount adjusted at the component supply cassette 80. Each component supply cassette 80 effectuates stable and proper suction and holding, having the individual suction rate improved. As shown in Fig. 8, although the positional displacement in the Y direction could be conventionally corrected by mechanically adjusting a installing center position P1 of a sprocket 80b which sends the carrier tape 101, thereby adjusting a center position P2 of the nozzle and a center position P3 of the component 103, it was complicate and practically difficult to mechanically adjust the installation positions of sprockets 80b of many component supply cassettes. At the same time, the positional displacement in the Y direction probably differs for each nozzle of a plurality of nozzles used for mounting, which cannot be coped with the above mechanical adjustment. In other words, only the positional displacement in the Y direction inherent in the component supply cassettes could be adjusted by the mechanical adjustment. In the present embodiment as shown in Fig. 10, the drive of the pulse motor 880 is controlled in place of mechanically adjusting the installing center position P1 of the sprocket 106, whereby the center position P3 of the component 103 can be shifted towards the center position P2 of the nozzle 10, thus enabling simpler and surer positional adjustment. Furthermore, the component positional adjustment can be previously executed to respond to the positional displacement of the nozzle, that is, not only the positional displacement in the Y direction specific to the component supply cassettes, but to the positional displacement in the Y direction possibly different for each nozzle of a plurality of nozzles used for mounting before each nozzle carries out the suction operation at the component supply cassette 80. Both the positional displacement specific to the nozzles and the positional displacement in the Y direction specific to the component supply cassettes are properly handled, and consequently each nozzle can stably and properly suck the component and the suction rate at the individual component supply cassette can be improved.

According to the third and eighth aspects of the present invention, in detecting the positional displacement as above, the positional displacement of the plurality of nozzles 10, ..., 10 along the X direction to the respective reference positions can be detected. An average value of the positional displacement amounts in the X direction to the reference positions of the plurality of nozzles 10, ..., 10 which are operated based on the detection result of the positional displacement detection is obtained, based on which the reference positions of the heads 4, 14, in other words, suction preparation positions of the heads 4, 14 when executing the component suction operation to the component supply cassettes 80, ..., 80 by the nozzles 10, ..., 10 are adjusted (with reference to Figs. 2A and 3A). Thereafter the plurality of nozzles 10, ..., 10 can accordingly hold the components 103, ..., 103 supplied to the component supply positions 89, ..., 89 from the component supply cassettes 80, ..., 80. Concretely, after the first nozzle 10 (left end nozzle in Fig. 9) is registered to the reference position, the positional displacement amounts Δx₂₋Δx₁₀ in the X direction between the normal reference positions (illustrated by black circles in Fig. 9) and the actual positions of the other second-fourth nozzles 10, ..., 10 are obtained by the control part 1000. The control part 1000 in turn obtains an average value of the positional displacement amounts Δx₂-Δx₁₀, adjusts the driving control of the working head 4 to shift the reference position of the working head 4, namely, reference positions of the first-10th nozzles 10, ..., 10 by the average value. Since the positional displacement amounts in the X direction are averaged, a degree of effects of the positional displacement is reduced, the labor for mechanical adjustment is eliminated, surer and more stable suction is carried out and the suction rate at the individual nozzle is improved.

In the arrangement, each of the nozzles 10 can hold the component 103 supplied to the component supply position 89 from the component supply cassette 80 while the positional displacement not only in the Y direction, but in the X direction is taken into consideration. Suction and holding by the component supply cassettes 80 can be more stably and properly conducted and the suction rate at each component supply cassette 80 can be improved furthermore.

According to the fourth and ninth aspects of the present invention, it is judged whether the positional displacement amount is in the range correctable through the driving control of the pulse motor 880. If the positional displacement amount is in the range correctable by the control, the drive of the pulse motor 880 is controlled to adjust the movement amount for moving the plurality of components 103, ..., 103 one by one along the Y direction to the component supply position 89. On the other hand, when the positional displacement amount is outside the range, the pulse motor 880 is not controlled, but the nozzle 10 may be moved by the positional displacement amount along the Y direction to perform the component holding operation.

In the arrangement, an optimum operation can thus be selected by properly judging in accordance with whether or not the positional displacement amount is in the range correctable by the driving control of the pulse motor 880. A mounting Tact can be cut further.

According to the fifth and 10th aspects of the present invention, it is judged whether or not the positional displacement amount of each nozzle is in the range correctable through the driving control of the corresponding pulse motor 880. When all of the positional displacement amounts are in the range, the movement amount for moving a plurality of components 103, ..., 103 one by one to the component supply position 89 along the Y direction is adjusted through the driving control of each pulse motor 880. On the other hand, if any of the plurality of positional displacement amounts is outside the range, one or a plurality of nozzles 10, ..., 10 other than the one or the plurality of nozzles with the positional displacement amount outside the range are let to hold components, and then the heads 4, 14 may be moved in the Y direction by an amount corresponding to the positional displacement amount outside the range to make the nozzle(s) with the positional displacement amount outside the range hold the component(s).

In such a manner, even when a plurality of components 103, ..., 103 are to be simultaneously sucked by a plurality of nozzles 10, ..., 10 at one time, depending on whether the positional displacement amount of each nozzle can be corrected by the driving control of the pulse motor 880 or not, an adequate judgment is made and an optimum operation can be selected to perform simultaneous suction operation at one time in a range in which suction at one time is possible. The mounting tact (mounting process time) can be furthermore reduced accordingly.

The present invention is not limited to the foregoing embodiment and can be carried out in various other modes.

For example, the present invention is not restricted to the apparatus and method in the above-described constitution, and is applicable to component mounting apparatuses in any structure wherein suction nozzles as an example of the component holding members hold components 103 supplied from a plurality of component supply cassettes 80 which hold and supply the plurality of components respectively, and then the suction nozzles place the held components to a board as an example of the body to be mounted although not specifically shown.

As the component supplying member, the form is not limited to the component supply cassette and the present invention is applicable similarly to a tray type or the like if only components from the component supply section of the tray type or the like are rearranged to a belt conveyor-shaped transfer member and supplied to the component supply position where the components can be sucked by nozzle(s) by driving the transfer member while a transfer amount by the transfer member is adjusted and changed with the positional displacement amount(s) of the nozzle(s) taken into consideration.

According to the first and sixth aspects of the present invention, the positional displacement along the second direction of the component holding member itself or of the component held by the component holding member to the reference position of the component holding member is detected. While an amount of the positional displacement along the second direction of the component holding member itself or of the component held by the component holding member to the reference position of the component holding member which is operated on the basis of the detection result at the time of detecting the positional displacement is taken into account, the movement amount for moving the plurality of components one by one along the second direction to the component supply position is adjusted at the component supplying member where the component is to be held by the component holding member based on the positional displacement amount, by controlling the drive of the component supply driving device which moves the components one by one along the second direction to the component supply position, whereby the position of the component at the component supply position can be adjusted. The component supplied to the component supply position with the movement amount adjusted at the component supplying member can be held by the component holding member including the positional displacement amount. The component can be stably and properly sucked and held by the component supplying member, with the suction rate at the component supplying member being improved.

According to the second and seventh aspects of the present invention, the positional displacements along the second direction of the component holding members themselves or of components held by the component holding members to respective reference positions of the component holding members are detected. While an amount of each of the positional displacements along the second direction of the component holding members themselves or of the components held by the component holding members to the reference positions of the component holding members which is operated on the basis of the detection result at the time of detecting the positional displacement is taken into account, the movement amount for moving the plurality of components one by one along the second direction to the component supply position is adjusted by controlling the drive of the component supply driving device which moves the plurality of components one by one along the second direction to the component supply positions based on each of the positional displacement amounts at each of the component supplying members where the components are to be held by the component holding members on the basis of each positional displacement amount, whereby the position of each component at each component supply position can be adjusted. Even when a plurality of components are to be sucked simultaneously at one time (collectively) by a plurality of component holding members, each component supplied to the component supply position with the movement amount adjusted at each component supplying member can be held by each component holding member including the positional displacement amount. Each component supplying member can stably and properly suck and hold the component and, the suction rate at the individual component supplying member can be improved.

According to the third and eighth aspects of the present invention, the positional displacement along the first direction of each of the component holding members themselves or of the components held by the component holding members to the respective reference positions of the component holding members is detected and, an average value of the amounts of the positional displacements along the first direction of the component holding members themselves or of components held by the component holding members to the respective reference positions of the component holding members which are operated on the basis of the detection result at the time of detecting the positional displacement is obtained. The arrangement enables the component holding members to hold components supplied to the component supply positions from the component supplying members after the reference position of the head is adjusted on the basis of the obtained average value.

As above, the positional displacement not only in the second direction, but in the first direction is taken into account when the components supplied to the component supply positions from the component supplying members are held by the component holding members, and consequently each component supplying member can more stably and properly suck and hold the component with the suction rate improved furthermore.

According to the fourth and ninth aspects of the present invention, whether or not the positional displacement amount is in the range correctable by the driving control of the component supply driving device is judged. The movement amount for moving the plurality of components one by one along the second direction is adjusted by the driving control of the component supply driving device when the positional displacement amount is in the range. On the other hand, when the positional displacement amount is outside the range, the component holding member before holding the component is moved by the positional displacement amount along the second direction without executing the driving control of the component supply driving device.

In the above arrangement, an optimum operation can be selected through an optimum judgment by whether or not the positional displacement is within the range correctable by the driving control of the component supply driving device, and therefore the mounting tact is reduced more.

According to the fifth and 10th aspects of the present invention, whether or not the amount, of each positional displacement is in the range correctable by the driving control of each component supply driving device is judged and, each movement amount for moving the plurality of components one by one along the second direction to each component supply position is adjusted by the driving control of each component supply driving device when all of the positional displacement amounts are within the range. Contrary, if any of the plurality of positional displacement amounts is out of the range, an arrangement may be devised so that the other component holding member(s) than the component holding member(s) having the positional displacement amount(s) outside the range are let to hold component(s), the head is moved along the second direction by an amount corresponding to the positional displacement amount outside the range, and the component holding member including the positional displacement amount outside the range is let to hold the component.

Accordingly, even when a plurality of components are to be sucked simultaneously at one time by a plurality of component holding members, an optimum operation can be selected to execute simultaneous suction at one time in a range where the suction is possible at one time based on an adequate judgment by whether each of the positional displacement amounts is in the range correctable by the driving control of the component supply driving device. The mounting tact is shortened more.

It is to be noted that, by appropriately combining the arbitrary embodiments out of the aforementioned various embodiments, the effects owned by the embodiments can be produced.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A component mounting apparatus in which each of a plurality of components (103) supplied to a component supply position (89) of a component supplying member (80) for supplying the components (103) is held by a component holding member (10) and then placed to a mounting base object (2),
the component holding member being set to a head (4, 14) which is movable in mutually orthogonal first direction (X) and second direction (Y), and
the component supplying member comprising a component supply driving device (880) for moving the components one by one along the second direction to the component supply position, thereby moving the plurality of components one by one along the second direction to the component supply position by driving the component supply driving device,
said component mounting apparatus comprising a positional displacement detecting device (9, 19) for detecting a positional displacement along the second direction of the component holding member itself or of the component held by the component holding member to a reference position of the component holding member,
whereby a movement amount for moving the plurality of components one by one along the second direction to the component supply position is adjusted through driving control to the component supply driving device at the component supplying member where the component is to be held by the component holding member based on an amount (Δy) of the positional displacement along the second direction of the component holding member itself or of the component held by the component holding member to the reference position of the component holding member which amount is operated on basis of detection result of the positional displacement detecting device, with the positional displacement amount being taken into account, so that the component supplied to the component supply position with the movement amount adjusted at the component supplying member is held by the component holding member including the positional displacement amount.

2. A component mounting apparatus which a plurality of components (103) supplied to corresponding respective component supply positions (89) of a plurality of component supplying members (80) for respectively supplying the components are respectively held by a plurality of component holding members (10) and then placed to a mounting base object (2),
the plurality of component holding members being set to one head (4, 14) which is movable in mutually orthogonal first direction (X) and second direction (Y), and
each of the component supplying members comprising a component supply driving device (880) for moving the plurality of components one by one along the second direction to the component supply position, thereby moving the plurality of components one by one along the second direction to the component supply position by driving the component supply driving device,
said component mounting apparatus being comprising a positional displacement detecting device (9, 19) for detecting a positional displacement along the second direction of each of the component holding members itself or of the component held by the component holding member to a reference position of each of the component holding members,
whereby a movement amount for moving the plurality of components one by one along the second direction to the component supply position is adjusted through driving control to each of the component supply driving devices at each of the component supplying members where the component is to be held by the component holding member based on an amount (Δy) of the positional displacement along the second direction of each of the component holding members itself or of the component held by the component holding member to the reference position of each of the component holding members which amount is operated on basis of detection result of the positional displacement detecting device, with the positional displacement amount being taken into account, so that the respective components supplied to the respective component supply positions with the movement amounts adjusted at the respective component supplying members are held by the respective component holding members having the respective positional displacement amounts.

3. A component mounting apparatus according to Claim 2, wherein the positional displacement detecting device (9, 19) can detect a positional displacement along the first direction of each of the plurality of component holding members itself or of the component held by the component holding member to the respective reference positions of the respective component holding members,
whereby an average value of the amounts (Δx) of the positional displacement along the first direction of the component holding members themselves or of the components held by the component holding members to the respective reference positions of the respective component holding members which are operated on the basis of the detection result of the positional displacement detecting device is obtained, based on which a reference position of the head is adjusted before the components supplied to the component supply positions from the component supplying members are held by the plurality of component holding members.

4. A component mounting apparatus according to Claim 1, in which, before holding components, whether or not the positional displacement amount is within a range correctable by driving control of the component supply driving device is judged, thereby adjusting the movement amount for moving the plurality of components one by one along the second direction to the component supply position through the driving control of the component supply driving device when the positional displacement amount is in the range, or moving the component holding member by the positional displacement amount along the second direction without executing the driving control of the component supply driving device when the positional displacement amount is outside the range.

5. A component mounting apparatus according to either Claim 2 or Claim 3, in which whether or not each of the positional displacement amounts is in a range correctable by driving control of each of the component supply driving devices is judged, thereby adjusting the movement amount for moving the plurality of components one by one along the second direction to the component supply position through driving control of each of the component supply driving devices when all of the positional displacement amounts are within the range, or letting the other component holding members than the component holding member having the positional displacement amount outside the range hold the components when any of the plurality of positional displacement amounts is outside the range, moving the component holding members by an amount corresponding to the positional displacement amount outside the range along the second direction, and then, letting the component holding member having the positional displacement amount outside the range hold the component.

6. A component mounting method for placing each of a plurality of components (103) supplied to a component supply position (89) of a component supplying member (80) for supplying the components to a mounting base object (2) after holding the component by a component holding member (10) set to a head (4, 14) movable in mutually orthogonal first direction (X) and second direction (Y), the method comprising:
detecting a positional displacement along the second direction of the component holding member itself or of the component held by the component holding member to a reference position of the component holding member; and
whereby adjusting a movement amount for moving the plurality of components one by one along the second direction to the component supply position through driving control of a component supply driving device (880) for moving the components one by one along the second direction to the component supply position at the component supplying member where the component is to be held by the component holding member based on an amount (Δy) of the positional displacement along the second direction of the component holding member itself or of the component held by the component holding member to the reference position of the component holding member which amount is operated on basis of detection result at time of detecting the positional displacement, with the positional displacement amount being taken into account, and thus holding the component supplied to the component supply position with the adjusted movement amount at the component supplying member by the component holding member having the positional displacement amount.

7. A component mounting method for respectively placing a plurality of components (103) supplied to respective component supply positions (89) from a plurality of component supplying members (80) for respectively supplying the components to a mounting base object (2) after respectively holding the components by a plurality of component holding members (10) set to a head (4, 14) movable in mutually orthogonal first direction (X) and second direction (Y), the method comprising:
detecting a positional displacement along the second direction of each of the component holding members itself or of the component held by the component holding member to a reference position of each of the component holding members; and
whereby adjusting each movement amount for moving the plurality of components one by one along the second direction to the component supply position through driving control of a component supply driving device (880) for moving the components one by one along the second direction to the component supply position at each component supplying member where the component is to be held by each of the component holding members based on an amount (Δy) of each positional displacement along the second direction of the component holding member itself or of the component held by the component holding member to the reference position of each of the component holding members which amount is operated on basis of detection result at time of detecting the positional displacement, with each positional displacement amount being taken into account, and thus holding each component supplied to the component supply position with the adjusted movement amount at each component supplying member by each component holding member having the positional displacement amount.

8. A component mounting method according to Claim 7, further comprising: detecting a positional displacement along the first direction of each of the component holding members itself or of the component held by the component holding member to the reference position of the component holding member at the detection time; and
obtaining an average value of the amounts (Δx) of the positional displacement along the first direction of the component holding members themselves or of the components held by the component holding members to the reference positions of the component holding members which are operated on the basis of the detection result at the time of detecting the positional displacement; then, adjusting a reference position of the head based on the obtained average value; and thereafter holding the components supplied to the component supply positions from the component supplying members by the component holding members.

9. A component mounting method according to Claim 6, further comprising judging whether or not the positional displacement amount is within a range correctable by driving control of the component supply driving device, thereby adjusting the movement amount for moving the plurality of components one by one along the second direction to the component supply position through the driving control of the component supply driving device when the positional displacement amount is in the range, or moving the component holding member by the positional displacement amount along the second direction without executing the driving control of the component supply driving device when the positional displacement amount is outside the range and thereafter holding the components.

10. A component mounting method according to either Claim 7 or Claim 8, further comprising judging whether or not each of the positional displacement amounts is in a range correctable by driving control of each of component supply driving devices, thereby adjusting each movement amount for moving the plurality of components one by one along the second direction to the component supply position through the driving control of each of the component supply driving devices when all of the positional displacement amounts are within the range, or letting the other component holding members than the component holding member having the positional displacement amount outside the range hold components when any of the plurality of positional displacement amounts is outside the range; moving the head by an amount corresponding to the positional displacement amount outside the range along the second direction; and thereafter letting the component holding member having the positional displacement amount outside the range hold the component.

## Patentansprüche

1. Komponenten-Montagevorrichtung, in welcher jede einer Mehrzahl von Komponenten (103), die zu einer Komponenten-Zuführposition (89) eines Komponenten-Zuführelements (80) für das Zuführen der Komponenten (103) zugeführt ist, durch ein Komponenten-Halteelement (10) gehalten und dann auf einem Montage-Basisobjekt (2) platziert wird, wobei
das Komponenten-Halteelement an einem Kopf (4, 14) angeordnet ist, welcher in rechtwinklig zueinander verlaufenden ersten Richtungen (X) und zweiten Richtungen (Y) bewegbar ist, und
das Komponenten-Zuführelement eine Komponenten-Zuführantriebsvorrichtung (880) umfasst, um Komponenten in der zweiten Richtung zu der Komponenten-Zuführposition eine nach der anderen zu bewegen, wobei auf diese Weise durch das Betätigen der Komponenten-Zuführantriebsvorrichtung die Mehrzahl der Komponenten einzeln in der zweiten Richtung zu der Komponenten-Zuführposition bewegt werden,
wobei die Komponenten-Montagevorrichtung eine Positionsverschiebungs-Erfassungsvorrichtung (9, 19), für das Erfassen einer Positionsverschiebung in der zweiten Richtung des Komponenten-Halteelements selbst oder der durch das Komponenten-Halteelement gehaltenen Komponente zu einer Bezugsposition des Komponenten-Halteelements umfasst,
wobei eine Bewegungsgröße für das jeweils nacheinander Bewegen der Mehrzahl von Komponenten in der zweiten Richtung zu der Komponenten-Zuführposition durch eine Antriebssteuerung zu der Komponenten-Zuführantriebsvorrichtung an dem Komponenten-Zuführelement eingestellt ist, wo die Komponente durch das Komponenten-Halteelement zu halten ist, basierend auf einer Größe (Δy) der Positionsverschiebung in der zweiten Richtung des Komponenten-Halteelementes selbst oder der durch das Komponenten-Halteelement gehaltenen Komponente zu einer Bezugsposition des Komponenten-Halteelements, wobei die Größe auf Basis des Erfassungsergebnisses der Positionsverschiebungs-Erfassungsvorrichtung unter Berücksichtigung der Größe der Positionsverschiebung hervorgebracht wird, so dass die zu der Komponenten-Zuführposition zugeführte Komponente mit der Bewegungsgröße, welche an dem Komponenten-Zuführelement eingestellt ist, einschließlich der Größe der Positionsverschiebung, durch das Komponenten-Halteelement gehalten wird.

2. Komponenten-Montagevorrichtung, in welcher eine Mehrzahl von Komponenten (103), die zu entsprechenden jeweiligen Komponenten-Zuführpositionen (89) einer Mehrzahl von Komponenten-Zuführelementen (80) für das jeweilige Zuführen der Komponenten zugeführt sind, jeweils durch eine Mehrzahl von Komponenten-Halteelementen (10) gehalten und dann auf einem Montage-Basisobjekt (2) platziert werden, wobei
die Mehrzahl von Komponenten-Halteelementen an einem Kopf (4, 14) angeordnet ist, welcher in rechtwinklig zueinander verlaufenden ersten Richtungen (X) und zweiten Richtungen (Y) bewegbar ist, und
jedes der Komponenten-Zuführelemente eine Komponenten-Zuführantriebsvorrichtung (880) umfasst, um die Mehrzahl von Komponenten in der zweiten Richtung zu der Komponenten-Zuführposition eine nach der anderen zu bewegen, wobei auf diese Weise durch das Betätigen der Komponenten-Zuführantriebsvorrichtung die Mehrzahl der Komponenten in der zweiten Richtung einzeln zu der Komponenten-Zuführposition bewegt wird,
wobei die Komponenten-Montagevorrichtung eine Positionsverschiebungs-Erfassungsvorrichtung (9, 19), für das Erfassen einer Positionsverschiebung in der zweiten Richtung von jedem der Komponenten-Halteelemente selbst oder der durch das Komponenten-Halteelement gehaltenen Komponente zu einer Bezugsposition von jedem der Komponenten-Halteelemente umfasst,
wobei eine Bewegungsgröße für das jeweils nacheinander Bewegen der Mehrzahl von Komponenten in der zweiten Richtung zu der Komponenten-Zuführposition durch eine Antriebssteuerung zu jeder der Komponenten-Zuführantriebsvorrichtungen an jedem der Komponenten-Zuführelemente eingestellt ist, wo die Komponente durch das Komponenten-Halteelement zu halten ist, basierend auf einer Größe (Δy) der Positionsverschiebung in der zweiten Richtung von jedem der Komponenten-Halteelemente selbst oder der durch das Komponenten-Halteelement gehaltenen Komponente zu der Bezugsposition von jedem der Komponenten-Halteelemente, wobei die Größe auf Basis des Erfassungsergebnisses der Positionsverschiebungs-Erfassungsvorrichtung unter Berücksichtigung der Größe der Positionsverschiebung hervorgebracht wird, so dass die jeweiligen zu den jeweiligen Komponenten-Zuführpositionen zugeführten Komponenten mit den Bewegungsgrößen, welche an den jeweiligen Komponenten-Zuführelementen eingestellt sind, durch die jeweiligen Komponenten-Halteelemente gehalten werden, welche die jeweiligen Größen der Positionsverschiebung aufweisen.

3. Komponenten-Montagevorrichtung nach Anspruch 2, wobei die Positionsverschiebungs-Erfassungsvorrichtung (9, 19) eine Positionsverschiebung in der ersten Richtung von jeder der Mehrzahl von Komponenten-Halteelemente selbst oder der von dem Komponenten-Halteelement gehaltenen Komponente zu den jeweiligen Bezugspositionen der jeweiligen Komponenten-Halteelementen erfassen kann,
wobei ein Mittelwert der Größen (Δx) der Positionsverschiebung in der ersten Richtung der Komponenten-Halteelemente selbst oder der durch die Komponenten-Halteelemente gehaltenen Komponenten zu den jeweiligen Bezugspositionen der jeweiligen Komponenten-Halteelemente, welche auf der Basis des Erfassungsergebnisses der Positionsverschiebungs-Erfassungsvorrichtung hervorgebracht werden, erzielt wird, auf dem basierend eine Bezugsposition des Kopfes eingestellt wird, bevor die den Komponenten-Zuführpositionen von den Komponenten-Zuführelementen zugeführten Komponenten durch die Mehrzahl von Komponenten-Halteelementen gehalten werden.

4. Komponenten-Montagevorrichtung nach Anspruch 1, wobei - bevor die Komponenten gehalten werden - entschieden wird, ob sich die Größe der Positionsverschiebung innerhalb eines durch die Antriebssteuerung der Komponenten-Zuführantriebsvorrichtung korrigierbaren Bereiches befindet oder nicht, wobei auf diese Weise die Bewegungsgröße für das jeweils nacheinander Bewegen der Mehrzahl von Komponenten in der zweiten Richtung zu der Komponenten-Zuführposition durch die Antriebssteuerung der Komponenten-Zuführantriebsvorrichtung eingestellt wird, wenn sich die Größe der Positionsverschiebung innerhalb des Bereichs befindet, oder das Komponenten-Halteelement durch die Größe der Positionsverschiebung in der zweiten Richtung bewegt wird, ohne die Antriebssteuerung der Komponenten-Zuführantriebsvorrichtung auszuführen, wenn sich die Größe der Positionsverschiebung außerhalb des Bereichs befindet.

5. Komponenten-Montagevorrichtung nach entweder Anspruch 2 oder Anspruch 3, wobei entschieden wird, ob sich jede der Größen der Positionsverschiebung innerhalb eines durch die Antriebssteuerung von jeder der Komponenten-Zuführantriebsvorrichtungen korrigierbaren Bereiches befindet oder nicht, wobei auf diese Weise die Bewegungsgröße für das jeweils nacheinander Bewegen der Mehrzahl von Komponenten in der zweiten Richtung zu der Komponenten-Zuführposition durch die Antriebssteuerung von jeder der Komponenten-Zuführantriebsvorrichtungen eingestellt wird, wenn sich jede der Größen der Positionsverschiebung innerhalb des Bereichs befindet, oder zugelassen wird, dass die anderen Komponenten-Halteelemente als das Komponenten-Halteelement, welches die Größe der Positionsverschiebung außerhalb des Bereichs aufweist, die Komponenten halten, wenn sich irgendeine der Mehrzahl von Größen der Positionsverschiebung außerhalb des Bereichs befindet, die Komponenten-Halteelemente in einem Maße entsprechend der Größe der Positionsverschiebung außerhalb des Bereichs in der zweiten Richtung zu bewegen, und dann zugelassen wird, dass das Komponenten-Halteelement, welches die Größe der Positionsverschiebung außerhalb des Bereichs aufweist, die Komponente hält.

6. Verfahren zum Montieren von Komponenten für das Platzieren von jeder einer Mehrzahl von Komponenten (103), welche zu einer Komponenten-Zuführposition (89) eines Komponenten-Zuführelements (80) für das Zuführen der Komponenten zu einem Montage-Basisobjekt (2) zugeführt werden, nach dem Halten der Komponente durch ein Komponenten-Halteelement (10), welches an einem Kopf (4, 14) angeordnet ist, der in rechtwinklig zueinander verlaufenden ersten Richtungen (X) und zweiten Richtungen (Y) bewegbar ist, wobei das Verfahren folgendes umfasst:
Erfassen einer Positionsverschiebung in der zweiten Richtung des Komponenten-Halteelements selbst oder der durch das Komponenten-Halteelement gehaltenen Komponente zu einer Bezugsposition des Komponenten-Halteelements; und
**dadurch** ein Einstellen einer Bewegungsgröße für das jeweils nacheinander Bewegen der Mehrzahl von Komponenten in der zweiten Richtung zu der Komponenten-Zuführposition durch die Antriebssteuerung einer Komponenten-Zuführantriebsvorrichtung (880), für das jeweils nacheinander Bewegen der Komponenten in der zweiten Richtung zu der Komponenten-Zuführposition an dem Komponenten-Zuführelement, wo die Komponente von dem Komponenten-Halteelement zu halten ist, basierend auf einer Größe (Δy) der Positionsverschiebung in der zweiten Richtung des Komponenten-Halteelementes selbst oder der durch das Komponenten-Halteelement gehaltenen Komponente zu der Bezugsposition des Komponenten-Halteelementes, wobei die Größe auf Basis eines Erfassungsergebnisses zum Zeitpunkt des Erfassens der Positionsverschiebung unter Berücksichtigung der Größe der Positionsverschiebung hervorgebracht wird und folglich das Halten der zu der Komponenten-Zuführposition zugeführten Komponente mit der eingestellten Bewegungsgröße an dem Komponenten-Zuführelement durch das Komponenten-Halteelement, welches die Größe der Positionsverschiebung aufweist.

7. Verfahren zum Montieren von Komponenten für das jeweilige Platzieren einer Mehrzahl von Komponenten (103), welche zu jeweiligen Komponenten-Zuführpositionen (89) von einer Mehrzahl von Komponenten-Zuführelementen (80) für das jeweilige Zuführen der Komponenten zu einem Montage-Basisobjekt (2) zugeführt werden, nach dem jeweiligen Halten der Komponenten durch eine Mehrzahl von Komponenten-Halteelementen (10), welche an einem Kopf (4, 14) angeordnet sind, der in rechtwinklig zueinander verlaufenden ersten Richtungen (X) und zweiten Richtungen (Y) bewegbar ist, wobei das Verfahren folgendes umfasst:
Erfassen einer Positionsverschiebung in der zweiten Richtung von jedem der Komponenten-Halteelemente selbst oder der durch das Komponenten-Halteelement gehaltenen Komponente zu einer Bezugsposition von jedem der Komponenten-Halteelemente; und
**dadurch** ein Einstellen von jeder Bewegungsgröße für das jeweils nacheinander Bewegen der Mehrzahl von Komponenten in der zweiten Richtung zu der Komponenten-Zuführposition durch die Antriebssteuerung einer Komponenten-Zuführantriebsvorrichtung (880), für das jeweils nacheinander Bewegen der Komponenten in der zweiten Richtung zu der Komponenten-Zuführposition an jedem der Komponenten-Zuführelemente, wo die Komponente von jedem der Komponenten-Halteelemente zu halten ist, basierend auf einer Größe (Δy) von jeder der Positionsverschiebungen in der zweiten Richtung des Komponenten-Halteelementes selbst oder der durch das Komponenten-Halteelement gehaltenen Komponente zu der Bezugsposition von jedem der Komponenten-Halteelemente, wobei die Größe auf Basis eines Erfassungsergebnisses zum Zeitpunkt des Erfassens der Positionsverschiebung unter Berücksichtigung jeder Größe der Positionsverschiebung hervorgebracht wird, und folglich das Halten jeder der Komponenten-Zuführposition zugeführten Komponente mit der eingestellten Bewegungsgröße an jedem Komponenten-Zuführelement durch jedes Komponenten-Halteelement, welches die Größe der Positionsverschiebung aufweist.

8. Verfahren zum Montieren von Komponenten nach Anspruch 7, welches ferner folgendes umfasst: Erfassen einer Positionsverschiebung in der ersten Richtung von jedem der Komponenten-Halteelemente selbst oder der durch das Komponenten-Halteelement gehaltenen Komponente zu der Bezugsposition des Komponenten-Halteelements zum Erfassungszeitpunkt; und
Erzielen eines Mittelwertes der Größen (Δx) der Positionsverschiebung in der ersten Richtung der Komponenten-Halteelemente selbst oder der durch die Komponenten-Halteelemente gehaltenen Komponenten zu den Bezugspositionen der Komponenten-Halteelemente, welche auf der Basis des Erfassungsergebnisses zum Zeitpunkt der Erfassung der Positionsverschiebung hervorgebracht werden; dann Einstellen einer Bezugsposition des Kopfes, basierend auf dem erzielten Mittelwert; und danach Halten der von den Komponenten-Zuführelementen zu den Komponenten-Zuführpositionen zugeführten Komponenten durch die Komponenten-Halteelemente.

9. Verfahren zum Montieren von Komponenten nach Anspruch 6, welches ferner folgendes umfasst: Prüfen, ob sich die Größe der Positionsverschiebung innerhalb eines Bereichs befindet, welcher durch eine Antriebssteuerung der Komponenten-Zuführantriebsvorrichtung zu korrigieren ist oder nicht, dabei Einstellen der Bewegungsgröße für das jeweils nacheinander Bewegen der Mehrzahl von Komponenten in der zweiten Richtung zu der Komponenten-Zuführposition durch die Antriebssteuerung der Komponenten-Zuführantriebsvorrichtung, wenn sich die Größe der Positionsverschiebung innerhalb des Bereichs befindet, oder Bewegen des Komponenten-Halteelements durch die Größe der Positionsverschiebung in der zweiten Richtung, ohne die Antriebssteuerung der Komponenten-Zuführantriebsvorrichtung auszuführen, wenn sich die Größe der Positionsverschiebung außerhalb des Bereichs befindet, und danach Halten der Komponenten.

10. Verfahren zum Montieren von Komponenten nach entweder Anspruch 7 oder Anspruch 8, welches ferner folgendes umfasst: Prüfen, ob sich jede der Größen der Positionsverschiebung innerhalb eines Bereichs befindet, welcher durch eine Antriebssteuerung von jeder der Komponenten-Zuführantriebsvorrichtungen zu korrigieren ist oder nicht, dabei Einstellen von jeder Bewegungsgröße für das jeweils nacheinander Bewegen der Mehrzahl von Komponenten in der zweiten Richtung zu der Komponenten-Zuführposition durch die Antriebssteuerung von jeder der Komponenten-Zuführantriebsvorrichtungen, wenn sich jede der Größen der Positionsverschiebung innerhalb des Bereichs befindet, oder Zulassen, dass die anderen Komponenten-Halteelemente als das Komponenten-Halteelement, welches die Größe der Positionsverschiebung außerhalb des Bereichs aufweist, die Komponenten halten, wenn sich irgendeine der Mehrzahl von Größen der Positionsverschiebung außerhalb des Bereichs befindet; Bewegen des Kopfes in einem Maße entsprechend der Größe der Positionsverschiebung außerhalb des Bereichs in der zweiten Richtung; und danach Zulassen, dass das Komponenten-Halteelement, welches die Größe der Positionsverschiebung außerhalb des Bereichs aufweist, die Komponente hält.

## Revendications

1. Dispositif de montage de composants dans lequel chaque composant d'une pluralité de composants (103) fournis à une position d'alimentation, en composants (89) d'un élément d'alimentation en composants (80) destiné à fournir les composants (103) est maintenu par un élément de maintien de composant (10) et ensuite placé sur un objet de base de montage (2),
l'élément de maintien de composant étant placé sur une tête (4, 14) qui est mobile dans une première direction (X) et une seconde direction (Y) mutuellement orthogonales, et
l'élément d'alimentation en composants comprenant un dispositif d'entraînement d'alimentation en composants (880) destiné à déplacer les composants un par un selon la seconde direction vers la position d'alimentation en composants, en déplaçant ainsi la pluralité des composants un par un selon la seconde direction vers la position d'alimentation en composants en entraînant le dispositif d'entraînement d'alimentation en composants,
ledit dispositif de montage de composants comprenant un dispositif de détection de déplacement de position (9, 19) destiné à détecter un déplacement de position selon la seconde direction de l'élément de maintien de composant lui-même ou du composant maintenu par l'élément de maintien de composant jusqu'à une position de référence de l'élément de maintien de composant,
grâce à quoi une quantité de déplacement pour déplacer la pluralité de composants un par un selon la seconde direction jusqu'à la position d'alimentation en composants est ajustée par l'intermédiaire d'une commande d'entraînement pour le dispositif d'entraînement d'alimentation en composants au niveau de l'élément d'alimentation en composants où le composant doit être maintenu par l'élément de maintien de composant sur la base d'une quantité (Δy) du déplacement de position selon la seconde direction de l'élément de maintien de composant lui-même ou du composant maintenu par l'élément de maintien de composant jusqu'à la position de référence de l'élément de maintien de composant, laquelle quantité est calculée sur la base du résultat de détection du dispositif de détection de déplacement de position, la quantité de déplacement de position étant prise en compte, de sorte que le composant fourni à la position d'alimentation en composants, la quantité de déplacement étant ajustée au niveau de l'élément d'alimentation en composants, est maintenu par l'élément de maintien de composant comprenant la quantité de déplacement de position.

2. Dispositif de montage de composants dans lequel une pluralité de composants (103) fournis à des positions d'alimentation en composants respectives correspondantes (89) d'une pluralité d'éléments d'alimentation en composants (80) destinés à fournir respectivement les composants sont respectivement maintenus par une pluralité d'éléments de maintien de composants (10) et ensuite placés sur un objet de base de montage (2),
la pluralité d'éléments de maintien de composants étant placés sur une tête (4, 14) qui est mobile dans une première direction (X) et une seconde direction (Y) mutuellement orthogonales, et
chacun des éléments d'alimentation en composants comprenant un dispositif d'entraînement d'alimentation en composants (880) destiné à déplacer la pluralité des composants un par un selon la seconde direction vers la position d'alimentation en composants, en déplaçant ainsi la pluralité des composants un par un selon la seconde direction vers la position d'alimentation en composants en entraînant le dispositif d'entraînement d'alimentation en composants,
ledit dispositif de montage de composants comprenant un dispositif de détection de déplacement de position (9, 19) destiné à détecter un déplacement de position selon la seconde direction de chacun des éléments de maintien de composants lui-même ou du composant maintenu par l'élément de maintien de composant jusqu'à une position de référence de chacun des éléments de maintien de composants,
grâce à quoi une quantité de déplacement pour déplacer la pluralité de composants un par un selon la seconde direction jusqu'à la position d'alimentation en composants est ajustée par l'intermédiaire d'une commande d'entraînement pour chacun des dispositifs d'entraînement d'alimentation en composants au niveau de chacun des éléments d'alimentation en composants où le composant doit être maintenu par l'élément de maintien de composant sur la base d'une quantité (Δy) du déplacement de position selon la seconde direction de chacun des éléments de maintien de composants lui-même ou du composant maintenu par l'élément de maintien de composant jusqu'à la position de référence de chacun des éléments de maintien de composants, laquelle quantité est calculée sur la base du résultat de détection du dispositif de détection de déplacement de position, la quantité de déplacement de position étant prise en compte, de sorte que les composants respectifs fournis aux positions d'alimentation en composants respectives, les quantités de déplacement étant ajustées au niveau des éléments d'alimentation en composants respectifs, sont maintenus par les éléments de maintien de composants respectifs qui présentent les quantités de déplacement de position respectives.

3. Dispositif de montage de composants selon la revendication 2, dans lequel le dispositif de détection de déplacement de position (9, 19) peut détecter un déplacement de position selon.la première direction de chaque élément parmi la pluralité d'éléments de maintien de composants lui-même ou du composant maintenu par l'élément de maintien de composant jusqu'aux positions de référence respectives des éléments de maintien de composants respectifs,
grâce à quoi une valeur moyenne des quantités (Δx) du déplacement de position selon la première direction des éléments de maintien de composants eux-mêmes ou des composants maintenus par les éléments de maintien de composants jusqu'aux positions de référence respectives des éléments de maintien de composants respectifs qui sont calculées sur la base du résultat de détection du dispositif de détection de déplacement de position est obtenue, sur la base de laquelle une position de référence de la tête est ajustée avant que les composants fournis aux positions d'alimentation en composants depuis les éléments d'alimentation en composants ne soient maintenus par la pluralité d'éléments de maintien de composants.

4. Dispositif de montage de composants selon la revendication 1, dans lequel, avant de maintenir les composants, il est évalué si la quantité de déplacement de position se trouve ou non à l'intérieur d'une plage pouvant être corrigée par une commande d'entraînement du dispositif d'entraînement d'alimentation en composants, en ajustant ainsi la quantité de déplacement pour déplacer la pluralité des composants un par un selon la seconde direction jusqu'à la position d'alimentation en composants par l'intermédiaire de la commande d'entraînement du dispositif d'entraînement d'alimentation en composants lorsque la quantité de déplacement de position se trouve dans sa plage, ou bien déplacer l'élément de maintien de composant de la quantité de déplacement de position selon la seconde direction sans exécuter la commande d'entraînement du dispositif d'entraînement d'alimentation en composants lorsque la quantité de déplacement de position se trouve en dehors de la plage.

5. Dispositif de montage de composants selon l'une ou l'autre de la revendication 2 ou de la revendication 3, dans lequel on évalue si chacune des quantités de déplacement de position se trouve ou non dans une plage pouvant être corrigée par une commande d'entraînement de chacun des dispositifs d'entraînement d'alimentation en composants, en ajustant ainsi la quantité de déplacement pour déplacer la pluralité des composants un par un selon la seconde direction jusqu'à la position d'alimentation en composants par l'intermédiaire d'une commande d'entraînement de chacun des dispositifs d'entraînement d'alimentation en composants lorsque toutes les quantités de déplacement de position se trouvent dans la plage, ou faire en sorte que les éléments de maintien de composants autres que l'élément de maintien de composant ayant la quantité de déplacement de position à l'extérieur de la plage maintiennent les composants lorsqu'une quantité quelconque parmi la pluralité des quantités de déplacement de position se trouve en dehors de la plage, déplacer les éléments de maintien de composants d'une quantité correspondant à la quantité de déplacement de position à l'extérieur de la plage selon la seconde direction, et ensuite faire en sorte que l'élément de maintien de composant présentant la quantité de déplacement de position en dehors de la plage maintienne le composant.

6. Procédé de montage de composants destiné à placer chaque composant parmi une pluralité de composants (103) fournis à une position d'alimentation en composants (89) d'un élément d'alimentation en composants (80) afin de fournir les composants à un objet de base de montage (2) après avoir maintenu le composant par le biais d'un élément de maintien de composant (10) placé sur une tête (4, 14) mobile dans une première direction (X) et une seconde direction (Y) mutuellement orthogonales, le procédé comprenant :
la détection d'un déplacement de position selon la seconde direction de l'élément de maintien de composant lui-même ou du composant maintenu par l'élément de maintien de composant vers une position de référence de l'élément de maintien de composant, et
grâce à quoi on ajuste une quantité de déplacement en vue de déplacer la pluralité des composants un par un selon la seconde direction jusqu'à la position d'alimentation en composants par l'intermédiaire de la commande d'entraînement d'un dispositif d'entraînement d'alimentation en composants (880) afin de déplacer les composants un par un selon la seconde direction jusqu'à la position d'alimentation en composants au niveau de l'élément d'alimentation en composants, où le composant doit être maintenu par l'élément de maintien de composant sur la base d'une quantité (Δy) du déplacement de position selon la seconde direction de l'élément de maintien de composant lui-même ou du composant maintenu par l'élément de maintien de composant jusqu'à la position de référence de l'élément de maintien de composant, laquelle quantité est calculée sur la base d'un résultat de détection au moment de la détection du déplacement de position, la quantité de déplacement de position étant prise en compte, et en maintenant ainsi le composant fourni à la position d'alimentation en composants avec la quantité de déplacement ajustée au niveau de l'élément d'alimentation en composants par l'intermédiaire de l'élément de maintien de composant ayant la quantité de déplacement de position.

7. Procédé de montage de composants destiné à placer respectivement une pluralité de composants (103) fournis à des positions d'alimentation en composants respectives (89) depuis une pluralité d'éléments d'alimentation en composants (80) afin de fournir respectivement les composants à un objet de base de montage (2) après avoir maintenu respectivement les composants par le biais d'une pluralité d'éléments de maintien de composants (10) placés sur une tête (4, 14) mobile dans une première direction (X) et une seconde direction (Y) mutuellement orthogonales, le procédé comprenant :
la détection d'un déplacement de position selon la seconde direction de chacun des éléments de maintien de composants lui-même ou du composant maintenu par l'élément de maintien de composant jusqu'à une position de référence de chacun des éléments de maintien de composants, et
grâce à quoi on ajuste chaque quantité de déplacement pour déplacer la pluralité de composants un par un selon la seconde direction jusqu'à la position d'alimentation en composants par l'intermédiaire d'une commande d'entraînement d'un dispositif d'entraînement d'alimentation en composants (880) afin de déplacer les composants un par un selon la seconde direction jusqu'à la position d'alimentation en composants au niveau de chaque élément d'alimentation en composants où le composant doit être maintenu par chacun des éléments de maintien de composants sur la base d'une quantité (Δy) de chaque déplacement de position selon la seconde direction de l'élément de maintien de composant lui-même ou du composant maintenu par l'élément de maintien de composant jusqu'à la position de référence de chacun des éléments de maintien de composants, laquelle quantité est calculée sur la base d'un résultat de détection au moment de la détection du déplacement de position, chaque quantité de déplacement de position étant prise en compte, et en maintenant donc chaque composant fourni à la position d'alimentation en composants avec la quantité de déplacement ajustée au niveau de chaque élément d'alimentation en composants par chaque élément de maintien de composant ayant la quantité de déplacement de position.

8. Procédé de montage de composants selon la revendication 7, comprenant en outre : la détection d'un déplacement de position selon la première direction de chacun des éléments de maintien de composants lui-même ou du composant maintenu par l'élément de maintien de composant jusqu'à la position de référence de l'élément de maintien de composant au moment de la détection, et
l'obtention d'une valeur moyenne des quantités (Δx) du déplacement de position selon la première direction des éléments de maintien de composants eux-mêmes ou des composants maintenus par les éléments de maintien de composants jusqu'à des positions de référence des éléments de maintien de composants qui sont calculées sur la base du résultat de détection au moment de la détection du déplacement de position, puis, l'ajustement d'une position de référence de la tête sur la base de la valeur moyenne obtenue, et après cela le maintien des composants fournis aux positions d'alimentation en composants depuis les éléments d'alimentation en composants par les éléments de maintien de composants.

9. Procédé de montage de composants selon la revendication 6, comprenant en outre l'évaluation du fait que la quantité de déplacement de position se trouve ou non dans une plage pouvant être corrigée par une commande d'entraînement du dispositif d'entraînement d'alimentation en composants, en ajustant ainsi la quantité de déplacement pour déplacer la pluralité des composants un par un selon la seconde direction vers la position d'alimentation en composants par l'intermédiaire de la commande d'entraînement du dispositif d'entraînement d'alimentation en composants lorsque la quantité de déplacement de position se trouve dans la plage, ou déplacer l'élément de maintien de composant de la quantité de déplacement de position selon la seconde direction sans exécuter la commande d'entraînement du dispositif d'entraînement d'alimentation en composants lorsque la quantité de déplacement de position se trouve en dehors de la plage et après cela en maintenant les composants.

10. Procédé de montage de composants selon l'une ou l'autre de la revendication 7 ou de la revendication 8, comprenant en outre l'évaluation du fait que chacune des quantités de déplacement de position se trouve ou non dans une plage pouvant être corrigée par la commande d'entraînement de chacun des dispositifs d'entraînement d'alimentation en composants, en ajustant ainsi chaque quantité de déplacement pour déplacer la pluralité des composants un par un selon la seconde direction vers la position d'alimentation en composants par l'intermédiaire de la commande d'entraînement de chacun des dispositifs d'entraînement d'alimentation en composants lorsque toutes les quantités de déplacement de position se trouvent dans la plage, ou faire en sorte que les éléments de maintien de composants autres que l'élément de maintien de composant présentant la quantité de déplacement de position en dehors de la plage maintiennent les composants lorsqu'une quantité quelconque parmi la pluralité des quantités de déplacement de position se trouve à l'extérieur de la plage, déplacer la tête d'une quantité correspondant à la quantité de déplacement de position à l'extérieur de plage selon la seconde direction, et après cela faire en sorte que l'élément de maintien de composant ayant la quantité de déplacement de position à l'extérieur de la plage maintienne le composant.
